(19) **Europäisches Patentamt / European Patent Office / Office européen des brevets**

(11) **EP 2 124 067 B1**

(12) **EUROPEAN PATENT SPECIFICATION**

(45) Date of publication and mention
of the grant of the patent:
**19.11.2014 Bulletin 2014/47**

(51) Int Cl.:
***G01R 15/20*** *(2006.01)*

(21) Application number: **08721811.1**

(22) Date of filing: **11.03.2008**

(86) International application number:
**PCT/JP2008/054395**

(87) International publication number:
**WO 2008/111586 (18.09.2008 Gazette 2008/38)**

(54) **CURRENT DETECTOR**

STROMDETEKTOR

DÉTECTEUR DE COURANT

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **14.03.2007 JP 2007064718**

(43) Date of publication of application:
**25.11.2009 Bulletin 2009/48**

(73) Proprietor: **Tamura Corporation
Tokyo 178-8511 (JP)**

(72) Inventors:
• **ANZAI, Hiroshi
Sakado-shi
Saitama 350-0214 (JP)**

• **KOBAYASHI, Masakazu
Sakado-shi
Saitama 350-0214 (JP)**

(74) Representative: **Isarpatent
Patent- und Rechtsanwälte
Postfach 44 01 51
80750 München (DE)**

(56) References cited:
| | |
|---|---|
| WO-A1-01/33242 | FR-A1- 2 764 707 |
| JP-A- 09 162 050 | JP-A- H09 162 050 |
| JP-A- 2001 050 987 | JP-A- 2001 230 137 |
| JP-A- 2001 264 364 | JP-A- 2003 031 421 |
| JP-A- 2003 031 421 | JP-U- 02 150 573 |
| US-A- 5 180 970 | US-B1- 6 426 617 |

## Description

[Technical Field]

The present invention relates to a current detector of a magnetic proportional type used for the measurement and detection of a current.

[Background Art]

As a prior art relating to a current detector of this type, there have been known current sensors converting a magnetic field generated by a current to be detected into voltage by a Hall element to indirectly detect a current value (see, for example, Japanese Patent Application Laid-open No. 2003-17347 and Japanese Patent Application Laid-open No. Hei 9-281152). These publicly known current sensors each include a core forming a magnetic circuit, and the Hall element is disposed in a gap (vacant space) formed in the core. The magnetic field generated in the core by the current to be detected moves around through the gap to be converted into a voltage signal by the Hall element.

As is shown by these prior arts, a toroidal type core or a laminate type core is used as the core of the current sensor. Out of these, the toroidal type core is obtained in such a way that a magnetic material in a band plate shape is first rolled up to be formed into a toroidal shape, part thereof is thereafter cut in a diameter direction, and a core gap is formed in this cut portion. When the toroidal type core is adopted, the yield of the material is high since the magnetic material is cut into the band plate shape to be used, and accordingly the material cost can be held down.

On the other hand, the laminate type core has a structure in which a plurality of plate-shaped cores are laminated in a thickness direction. Each of the plate-shaped cores is formed by the punching of a plate of a magnetic material, and therefore, when the laminate type core is adopted, the yield as a material is lower than that of the toroidal type.

Generally, in the toroidal type core, a directional silicon steel plate is used as the magnetic material. When the directional silicon steel plate is cut along its easy magnetization direction to be worked into the band plate shape, its roll-up direction agrees with the easy magnetization direction, so that good magnetic characteristics (saturation characteristic, linearity, hysteresis width) as the core for current detection are finally obtained. However, after the band-shaped material is rolled up, in order to recover the directivity of the material, the toroidal type core has to go through processes such as long-hour heat treatment (annealing) and impregnation of an impregnant in a gap of the rolled-up material followed by long-hour drying. Therefore, when the toroidal type core is adopted, there arises a problem of an increased processing cost even though material cost itself can be held down.

On the other hand, as for the laminate type core, even if its material is given an easy magnetization characteristic, its structure does not allow an easy magnetization direction to agree with a direction in which magnetism generated by a current to be detected moves around. Therefore, as the magnetic material of the laminate type core, a permalloy (iron-nickel alloy) having excellent magnetic characteristics is generally used. The permalloy has far higher magnetic permeability than that of silicon steel and exhibits excellent magnetic characteristics (linearity, hysteresis width) as the core for current detection. However, since the materials themselves of the permalloy are expensive, the permalloy has a problem that it is not very much suitable for a relatively large core and the shape with a poor yield such as the laminate type core.

FR 2 764 707 is directed to a measuring transformer, for measuring a current independently or in combination with another current or a voltage, has a magnetic circuit consisting of a metal torus with a gap accommodating a magnetic field detector, the novelty being that the torus is a laminated torus with one or more lamina of a first material, having high initial permeability and good linearity at low current, and one or more lamina of a second material having low initial permeability and good saturation resistance at high current. Preferably the first material is a Fe/80% Ni alloy and the second material is a Fe/50% Ni alloy. Also claimed is an electricity meter equipped with the above measuring transformer.

JP H09 162050 aims to solve the problem of how to sense accurately a primary current from its small current region to its large one. To this end what is disclosed is an annular core surrounding a primary conductor and having a wound secondary coil thereon, laminating alternately plates having respectively comparably high and low permeabilities. Thereby, in the small current region of a primary current, a micro-current is sensed by the high-permeability portion with a low magnetic resistance and to its large current region it can be sensed accurately by the low-permeability portion with a high magnetic saturation point.

JP 2003 031421 aims to solve the problem of how to provide a ring core and its manufacturing method, which has a high productivity and high dimensional precision. To this end the reference discloses the ring core having a gap provided in a part of an annular core comprises many stamped core pieces having the same shape. The core pieces are laminated and upper and lower core pieces are bonded with one or more of a rugged caulking zone, adhesives and welding. A band plate-like silicon steel sheets is stamped to punch annular core pieces one after another, and the pieces are laminated and fixed to manufacture the ring core.

JP 2001 050987 aims to solve the problem of how to provide a technique which can miniaturize an apparatus as a whole and measure a current more precisely and how to obtain a technique which can measure the DC component of a current. To this end the reference discloses a current measuring apparatus that comprises a detecting unit and a measuring unit. An electrical interconnection is passed through the hollow part of the detecting unit. A current flows in the electrical interconnection to a load from a power-supply device. A magnetoresistance element is embedded in the detecting unit. When a current flows, a magnetic field is generated, and the electric resistance value of the magnetoresistance element is changed.

Under such circumstances, one of the objects in the technical field of the current detector is to hold down the material cost and processing cost necessary for the manufacture and to maintain good magnetic characteristics as the core for current detection.

[Disclosure of the Invention]

The present invention is a current detector which passes, in a magnetic core, an electric field generated by the conduction of a current to be detected and converts the magnetic field passing in a gap thereof into output voltage by a Hall element. The current detector adopts the magnetic core having a structure in which a plurality of metal plates whose magnetic materials are different from each other are laminated, thereby solving the aforesaid problem.

Specifically, since the current detector adopts the magnetic core having the structure in which the plural metal plates are laminated, the processing cost can be held down compared with a case where a toroidal type core is adopted. Further, the plural metal plates are made of the different magnetic materials and are mixedly present in a laminated state in the magnetic core, and therefore, even if they include an expensive magnetic material, a ratio of its amount used in an amount used of all the materials can be reduced to small, which can accordingly hold the material cost down.

Further, since the aforesaid magnetic core mixedly uses the magnetic materials of different kinds, the magnetic characteristic as the whole magnetic core is not greatly influenced by any one kind of the magnetic material. In this case, for example, even if one kind of the magnetic material is inferior in the magnetic characteristics (saturation characteristic, linearity, hysteresis width) compared with the other kind, this inferiority is compensated for by the good magnetic characteristic that the other kind of the magnetic material has, which enables the whole magnetic core to exhibit good magnetic characteristics.

As a more practical mode, the current detector of the present invention adopts a magnetic core having a structure in which a plurality of directional silicon steel plates whose easy magnetization directions are different from each other are laminated. Generally, a natural form of using the directional silicon steel plate given the easy magnetization as a core would be to roll it up in a direction in which magnetism moves around, as in a conventional toroidal type. If a magnetic core having a structure in which a large number of silicon steel plates with the same directivity are laminated is adopted, the easy magnetization direction as a whole is restricted to one direction, so that some part has a high magnetic resistance and some part has a low magnetic resistance when the magnetism moves around. In this case, even though the saturation characteristic as the core for current detection is perfect, linearity of output voltage with respect to a current to be detected extremely deteriorates and remanent magnetic flux becomes large, and hence this is not suitable for practical use as a current detector.

In the present invention, on the other hand, since the silicon steel plates whose easy magnetization directions are different from each other are mixedly present in the magnetic core, the easy magnetization direction as the whole magnetic core is not restricted to one direction, and as a result, the aforesaid uneven magnetic resistance in the direction in which the magnetic field moves around is solved. Consequently, it is possible to achieve good magnetic characteristics (good linearity, smaller hysteresis width) as the core for current detection, and a current detector suitable for practical application is obtained.

The above-described magnetic core has a structure in which two kinds of the directional silicon steel plates whose easy magnetization directions are orthogonal to each other are laminated. Alternatively, the above-described magnetic core has a structure in which two kinds of the directional silicon steel plates whose easy magnetization directions are orthogonal to each other are alternately laminated.

By laminating the directional silicon steel plates so that their easy magnetization directions are orthogonal to each other as described above, it is possible to form a magnetic circuit in a substantially rectangular shape in a periphery of a current to be detected when seen in a laminating direction thereof. Therefore, the magnetism generated by the current to be detected passes in the magnetic circuit formed in the magnetic core to be capable of move around in a good condition.

Further, when the directional silicon steel plates are laminated so that their easy magnetization directions become orthogonal to each other, the substantially angular shape (rectangular shape) is also suitable as the shape of the whole magnetic core. In this case, the magnetic core has a pair of long side portions and a pair of short side portions facing each other across a current conduction part, and the easy magnetization directions of the directional silicon steel plates are defined along lengths directions of the long side portions and the short side portions respectively.

Such a structure can reduce the magnetic resistance to minimum in the long side portions and the short side portions, so that the whole magnetic core can exhibit good magnetic characteristics.

Further, the present invention adopts a magnetic core having a structure in which a nondirectional silicon steel plate and an iron-nickel alloy plate are laminated, thereby capable of solving the aforesaid problem.

The nondirectional silicon steel plate has a large remanent magnetic flux even though having no special problem in linearity and saturation characteristic as the core for current detection, and therefore, it is a magnetic material generally not used in a current detector. However, when the structure in which the iron-nickel alloy (permalloy) plate having especially excellent characteristics as the magnetic material and the nondirectional silicon steel plate are mixedly present is adopted in the core for current detection, the drawback of the nondirectional silicon steel plate is compensated for, and the whole magnetic core can exhibit good magnetic characteristics.

Further, by mixedly using the nondirectional silicon steel plate whose material cost is low and the iron-nickel alloy plate whose material cost is high, it is possible to reduce a ratio of an amount used of the expensive iron-nickel alloy plate to an amount used of all the materials, which can accordingly hold the material cost down.

[Brief Description of Drawings]

[Fig. 1] Fig. 1 is a perspective view showing a current detector of a first embodiment disassembled into constituent elements;

[Fig. 2] Fig. 2 is a vertical sectional view taken along the II-II line in Fig. 1;

[Fig. 3] Fig. 3 is a graph showing output linearity of output voltage (V) when known input current (A) is detected by using the current detector;

[Fig. 4] Fig. 4 is a table showing a list of linearity error ratios in comparative examples 1, 2, an example, and a conventional example;

[Fig. 5] Fig. 5 is a table showing a list of hysteresis widths in the comparative examples 1, 2, the example, and the conventional example;

[Figs. 6] Figs. 6 are cross-sectional views showing the structures of current detectors of a second to a fourth embodiment; and

[Fig. 7] is a perspective view showing a current detector of a fifth embodiment disassembled into constituent elements.

[Best Mode for Carrying out the Invention]

Hereinafter, embodiments of the present invention will be described with reference to the drawings.

[First Embodiment]

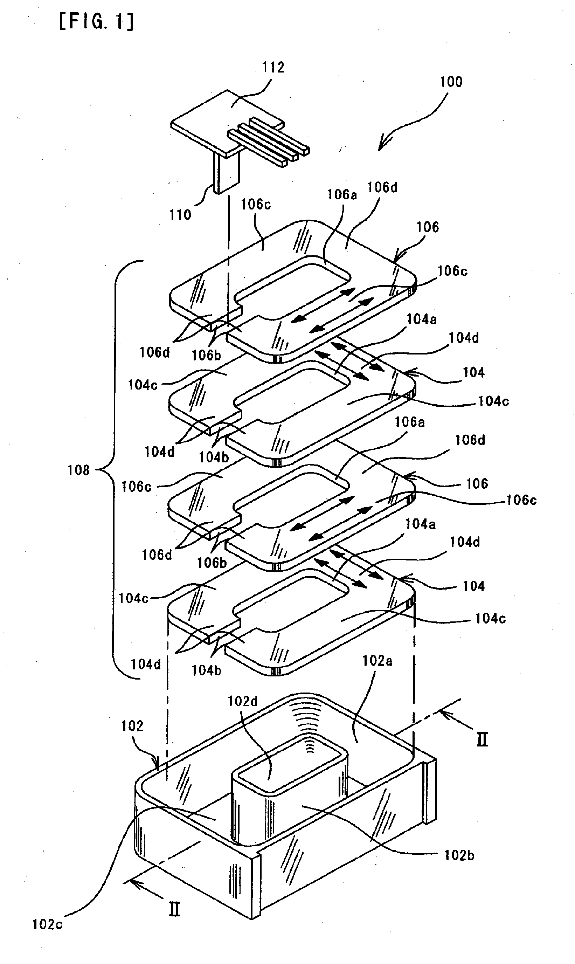

Fig. 1 is a perspective view showing a current detector 100 of a first embodiment disassembled into constituent elements. The current detector 100 includes a resin case 102, and a plurality of sheet cores 104, 106 in a laminated state are housed in the resin case 102.

These sheet cores 104, 106 in the housed state in the resin case 102 constitute one magnetic core 108. Incidentally, though the numbers of the sheet cores 104, 106 each are two in Fig. 1, a larger number of them are actually provided, and they are not shown in Fig. 1.

The sheet cores 104, 106 are both in a substantially angular C-shape, and the sheet cores 104, 106 in such a shape are formed by the punching of a plate-shaped magnetic material. At this time, openings 104a, 106a are formed at center positions of the sheet cores 104, 106 respectively, and slits 104b, 106b for gap extending from the openings 104a, 106a toward one-side edges are formed. The openings 104a, 106a are in a substantially rectangular shape so as to match the outer shape of sheet cores 104, 106.

Further, the sheet cores 104, 106 have a pair of long side portions 104c, 106c and a pair of short side portions 104d, 106d which face each other across the openings 104a, 106a provided in the centers. In the short side portions 104d, 106d out of these, the aforesaid slits 104b, 106b for gap are formed.

When the sheet cores 104, 106 in the laminated state are housed in the resin case 102, the openings 104a, 106a and the slits 104b, 106b thereof overlap with each other when seen in the laminating direction. Consequently, in the state where the single magnetic core 108 is formed from a large number of the sheet cores 104, 106, a continuous through hole is formed in the center position thereof, and a core gap is formed in part of a circumferential direction.

In the resin case 102, a housing portion 102a and a guide sleeve 102b are formed. In the housing portion 102a, an upper side shown in Fig. 1 is opened and a bottom plate 102c is formed on a lower side. The guide sleeve 102b extends upward from an upper surface of the bottom plate 102c, and the inside thereof is formed as a hollow current conduction part 102d. The outer shape of the guide sleeve 102 is slightly smaller than the openings 104a, 106a of the sheet cores 104, 106 and an inside dimension of the housing portion 102a is larger than the outer shape of the sheet cores 104, 106. Therefore, when the sheet cores 104, 106 are housed in the resin case 102, the openings 104a, 106a are guided along an outer surface of the guide sleeve 102b, which facilitates the mutual positioning of the sheet cores 104, 106.

In the resin case 102, a Hall element 110 is housed as well as the sheet cores 104, 106. The Hall element 110 is mounted on a circuit board 112, and the circuit board 112 is housed so as to be stacked on an upper surface of the outermost sheet core 106. At this time, the Hall element 110 is inserted through the slits 104b, 106b for gap of the sheet cores 104, 106, so that it is positioned in the core gap of the magnetic core 108.

In the first embodiment, directional silicon steel plates are used as the sheet cores 104, 106. As the sheet cores 104, 106, the silicon steel plates whose directivities (easy magnetization directions) are different from each other are used. Specifically, the easy magnetization direction (arrow direction in the drawing) of the sheet cores 104 agrees with a length direction of the short side portions 104d and the easy magnetization direction (arrow direction in the drawing) of the other sheet cores 106 agrees with a length direction of the long side portions 106c.

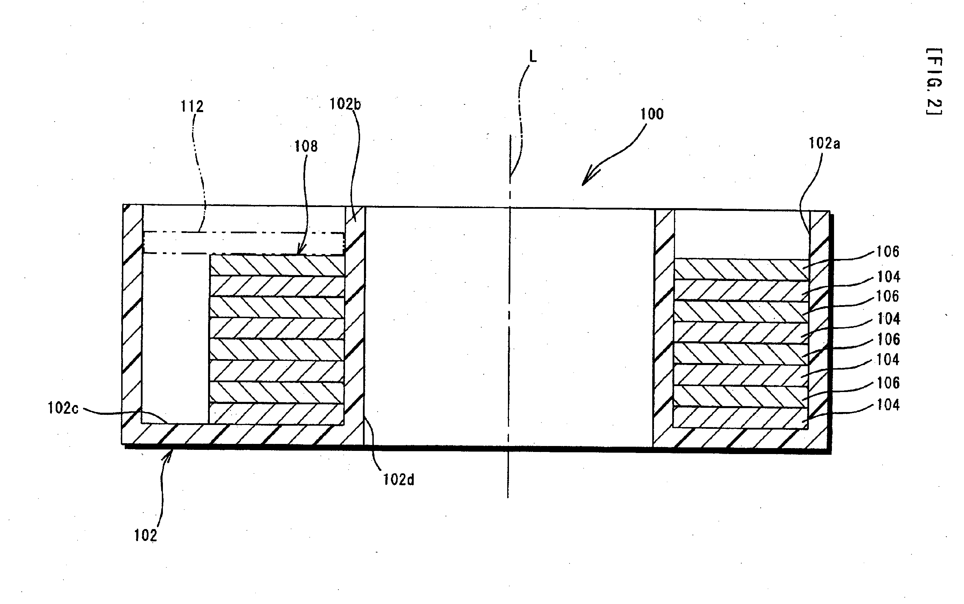

Fig. 2 is a view showing a vertical cross section of the current detector 100 in its assembled state (taken along the II-II line in Fig. 1). Note that the position of the cross section (II-II line) is a position not overlapping with the gaps in the short side portions 104d, 106d. The sheet cores 104, 106 are stacked in the resin case 102 to form the magnetic core 108 as described above, and the inside of the resin case 102 is sealed by potting resin, not shown, while the circuit board 112 on which the Hall element 110 is mounted is housed, so that the current detector 100 becomes a finished product. Incidentally, lead terminals of the circuit board 112 are not buried in the potting resin and hence external wiring connection is possible. Further, the number of the sheet cores 104, 106 shown in Fig. 2 is only an illustrative example and may be larger or may be smaller.

The current detector 100 can be used in a state where a current to be detected is conducted in a direction penetrating through its current conduction part 102d upward and downward (an axis L direction in Fig. 2). When the current to be detected is conducted in the current conduction part 102d, a magnetic field generated thereby moves around through the inside of the magnetic core 108. At this time, the magnetic field passing through the gap of the magnetic core 108 is converted into a voltage signal in the Hall element 110, and the voltage signal after amplified by an amplifier circuit formed in the circuit board 112 is extracted as a detection signal.

Here, two kinds of the directional silicon steel plates whose easy magnetization directions are different from each other are used as the sheet cores 104, 106 as described above, and especially in the first embodiment, it is understood that the sheet cores 104, 106 are alternately laminated to form the single magnetic core 108. That is, in the sheet cores 104, the magnetism easily permeates (magnetic permeability is high) in the length direction of the short side portions 104d and the magnetism does not easily permeate (magnetic permeability is low) in the length direction of the long side portions 104c. On the contrary, it is understood that the other sheet cores 106 have a property that the magnetism easily permeates (magnetic permeability is high) in the length direction of the long side portions 106c and the magnetism does not easily permeate (magnetic permeability is low) in the length direction of the short side portions 106d.

Based on the above-described properties of the sheet cores 104, 106, the inventors of the present invention have noticed that the following advantages are obtained when the sheet cores 104, 106 are alternately laminated to form the magnetic core 108. Specifically, when only the sheet cores 104 or only the sheet cores 106 are laminated in plurality to form the magnetic core, some part inside the magnetic core has a high magnetic resistance and some part has a low magnetic resistance in the direction in which the magnetism moves around, but when two kinds of the sheet cores 104, 106 are alternately laminated as in, for example, the first embodiment, the uneven magnetic resistance inside the magnetic core 108 can be solved.

[Example]

The findings by the inventors will be verified below based on concrete examples.

[Verification of Output Linearity]

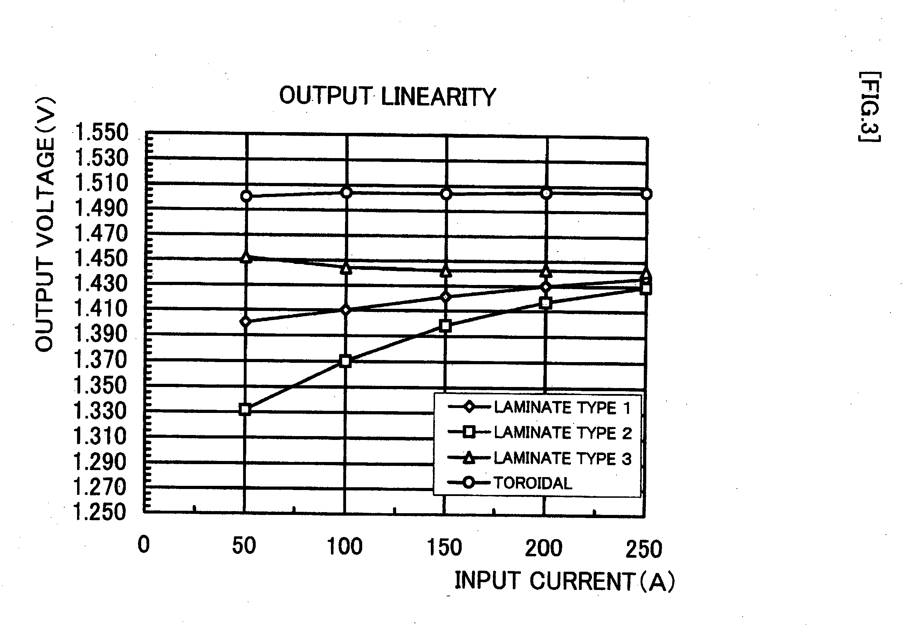

Fig. 3 is a graph showing output linearity of output voltage (V) when know input current (A) is detected (measured) by using the current detector 100. The "output linearity" is an index for evaluating whether or not the voltage signal output from the Hall element 110 linearly changes in accordance with a change in a value of the current to be detected passed in the current conduction part 102d of the current detector 100. Here, the output voltage (V) with respect to the input current (A) was plotted under the following conditions and the output linearity was evaluated from the result.

One adopting the magnetic core 108 of the first embodiment was prepared as an example, and one in which a core is composed of a laminate of only the sheet cores 104 and one composed of a laminate of only the sheet cores 106 were prepared as comparative examples 1, 2. Further, as a conventional example, one using a toroidal type core was prepared.

Regarding the example, the comparative example 1, the comparative example 2, and the conventional example described above, the output voltage (V) when the know input current (A) was conducted was observed. In the observation at this time, a rated value of the input current was set to 200 A and a current value was changed in five steps (50A, 100A, 150A, 200A, 250A). The points of each of the output voltages (V) plotted in Fig. 3 (represented by the marks ◊, □, △, ○) are a four multiple, a two multiple, a 4/3 multiple, an equimultiple, and a 1.25 multiple (rated value conversion) of outputs from the Hall element 110, with respect to the respective input currents (A).

In Fig. 3, "laminate type 3 (mark △)" shows the result of the example. As for the others, "laminate type 1 (mark ◊)" shows the result of the comparative example, and "laminate type 2 (mark □)" shows the result of the comparative example 2. Further, "toroidal (mark ○)" shows the result of the conventional example.

From the output linearities shown in Fig. 3, the following points are apparent.

   (1) The conventional example using the toroidal type core was the most excellent in the output linearity.

Further, since the level of the output voltage (C) is higher than those of the others as a whole, it can be said that magnetic permeability as the core is high.
(2) In the example using the first embodiment (laminate type 3), output linearity comparable with that of the comparative example using the toroidal type core was obtained.
(3) The comparative examples 1, 2 using only the sheet cores 106 and only the sheet cores 104 respectively (laminate types 1, 2) were inferior in the output linearity to the conventional example using the toroidal type core and the example using the first embodiment (laminate type 3).
(4) The conventional example using the toroidal type core is relatively low in its material cost as described above, but since a lot of man-hours and long hours are required for its processing, its total manufacturing cost is higher than that of the example.

As a result of the comprehensive evaluation of the above results (1) to (4), it has been verified that the adoption of the example using the magnetic core 108 of the first embodiment as a product can achieve both a reduction in manufacturing man-hours and a cost reduction at the same time because the example exhibits the excellent linearity, and moreover, its manufacturing cost can be made lower than that of the conventional toroidal type.

[Verification Using Linearity Error Ratio]

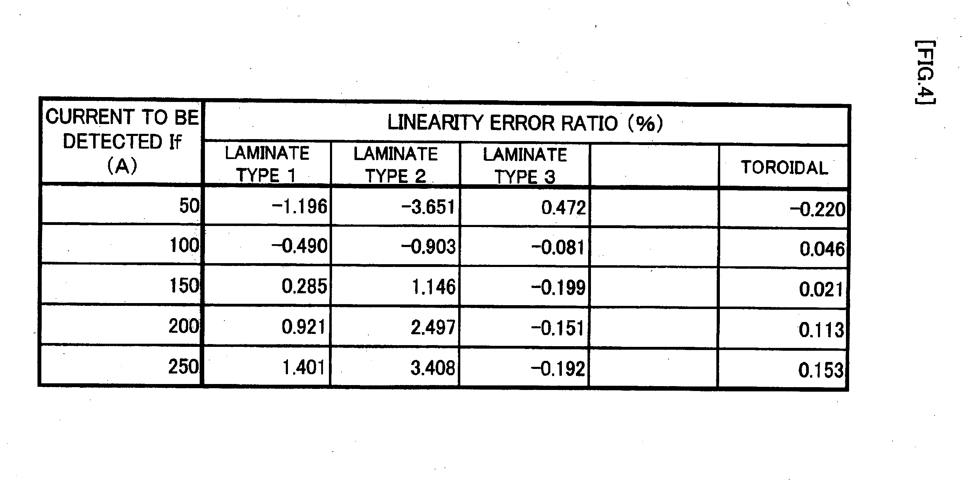

Next, Fig. 4 is a table showing a list of linearity error ratios of the comparative examples 1, 2 (laminate types 1, 2), the example (laminate type 3), and the conventional example using the toroidal type core. The "linearity error ratio" mentioned here refers to an error, expressed in percentage, of each of the five points (output voltages (Vout)), which were used for the evaluation of the output linearity, relative to an average A of the five points. It can be said that, as the "linearity error ratio" at each of the points is smaller, the numerical value also shows that the output linearity is more excellent. Incidentally, the linearity error ratio ($\varepsilon$) can be expressed by, for example, the following numerical expression.

$$\varepsilon = (Vout - A)/A \times 100 (\%)$$

The following points are apparent from the list of the linearity error ratios shown in Fig. 4.

(1) In the conventional example using the toroidal type core, the linearity error ratio falls within a range of -0.22 to 0.153 (%), and the error ratios at the respective points (50A, 100A, 150A, 200A, 250A) all were also the smallest (absolute value evaluation).
(2) In the example using the first embodiment (laminate type 3), the linearity error ratio falls within a range of -0.192 to 0.472 (%), and the linearity error ratio was small to a degree comparable with that of the conventional example using the toroidal type core (absolute value evaluation). Further, the error ratios at the respective points were smaller than those of the other comparative examples (laminate types 1, 2) (also the absolute value evaluation).
(3) In the comparative examples 1, 2 (laminate types 1, 2) using only the sheet cores 106 and only the sheet cores 104 respectively, the linearity error ratios were higher than those of the conventional example using the toroidal type core and the example using the first embodiment (laminate type 3) (absolute value evaluation).

As described above, it is seen that the example using the magnetic core 108 of the first embodiment exhibits a low linearity error ratio (absolute value evaluation) and the numerical value also indicates that it exhibits excellent output linearity. On the other hand, when the magnetic core 108 is formed by laminating either only the sheet cores 104 or only the sheet cores 106, good output linearity is not obtained in any of these cases. It can be thought that this is because of the uneven magnetic resistance inside the core as is apparent from the findings of the inventors.

[Verification Using Hysteresis Width]

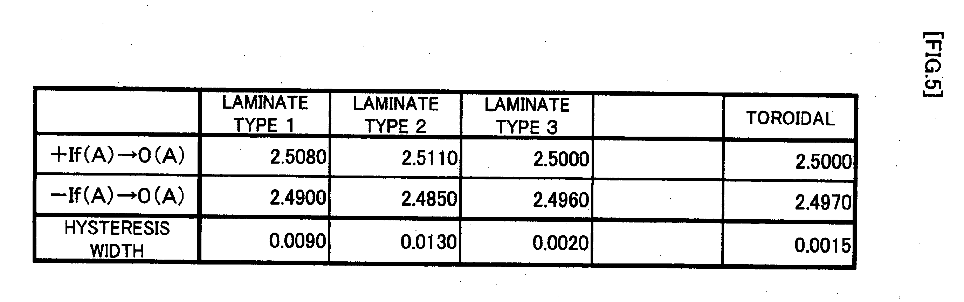

Next, Fig. 5 is a table showing a list of the hysteresis widths of the comparative examples 1, 2 (laminate types 1, 2), the example (laminate type 3), and the conventional example. The "hysteresis width" is an index for evaluating a remanent magnetic flux characteristic of a core for current detection. Concretely, after a magnetic field was passed in the core by the conduction of a current to be detected in a forward direction and an inverse direction, the conduction of the current to be detected was stopped, and output voltages (V) at this time were observed. Here, the Hall element 110 was initially adjusted so that the output voltage became 2.5 (V) when the current to be detected is 0 (A).
In the list in Fig. 5, (+If(A) →0(A)) on the top row shows a value of the output voltage (V) when the conduction of the current to be detected is stopped after it is conducted in the forward direction. Further, (-If(A)→0(A)) on the middle row shows a value of the output voltage (V) when the conduction of the current to be detected is stopped after it is conducted in the inverse direction. In both cases, an offset from 2.5 (V) indicates an offset of the output voltage (V) due to the remanent magnetic flux. (Hysteresis width) on the bottom row shows a final offset amount of the output voltage (V) due to the remanent magnetic flux (a medium point of those in the top row and the bottom row).
From the list of the hysteresis widths shown in Fig. 5, the following points are apparent.

(1) In the conventional example using the toroidal type core, the hysteresis width was +0.0015 (V), which was the smallest among all.

(2) In the example using the first embodiment (laminate type 3), the hysteresis width was +0.0020 (V), which was substantially comparable with that of the conventional example using the toroidal type core.

(3) In the comparative examples 1, 2 using only the sheet cores 106 and only the sheet cores 104 respectively (laminate types 1, 2), the hysteresis widths were larger compared with those of the conventional example using the toroidal type core and the example using the first embodiment (laminate type 3).

As described above, the example using the magnetic core 108 of the first embodiment has turned out to be excellent in the remanent magnetic flux characteristic as the core for current detection because its hysteresis width is small. On the other hand, when the magnetic core 108 is formed by laminating only the sheet cores 104 or only the sheet cores 106, the remanent magnetic flux characteristic is poorer and the hysteresis width is large than those of the example in both cases.

[Verification of Saturation Characteristic]

Further, regarding the example, the comparative examples 1, 2, and the conventional example, the inventors of the present invention additionally conducted the verification of the magnetic saturation characteristic, and as a result, it has been confirmed that no saturation takes place in any of the cases when the current to be detected is within the range of ($\pm$200A) (not shown).

As is verified based on the example, it has been confirmed that, when the sheet cores 104, 106 are alternately laminated to form the magnetic core 108 as in the first embodiment, excellent magnetic characteristics comparable with those of the conventional toroidal type can be obtained.

[Second to Fourth Embodiments]

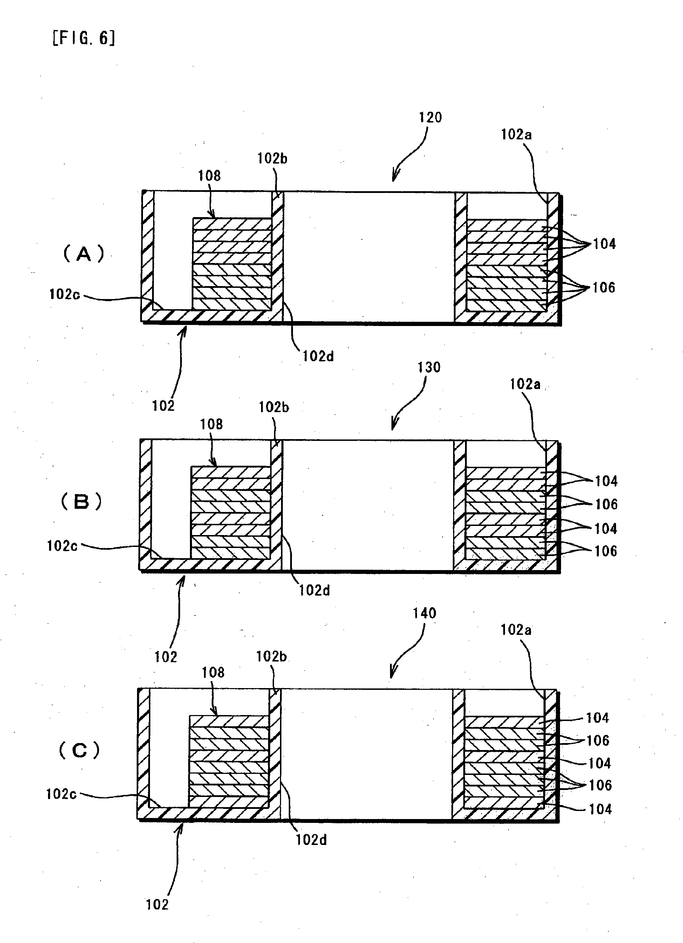

Figs. 6 are cross-sectional views showing the structures of current detectors 120, 130, 140 of a second to a fourth embodiment. Hereinafter, they will be described. Note that in the following description, the same items as those of the first embodiment will be denoted by the same reference numerals and symbols, and repeated description thereof will be omitted.

Fig. 6(A): In the current detector 120 of the second embodiment, a layer of two kinds of sheet cores 104, 106 are divided in an upper portion and a lower portion in an up and down laminating direction. For example, an upper half thereof is a layer composed only of the sheet cores 104, and a lower half is a layer composed only of the other sheet cores 106.

Fig. 6(B): In the current detector 130 of the third embodiment, layers composed of two kinds of the sheet cores 104, 106 respectively are alternately laminated, each layer having a predetermined number (two or more) of the sheet cores 104 or 106. For example, two sheets in the uppermost layer are the sheet cores 104, two sheets in a layer thereunder are the other sheet cores 106, and two sheets in a layer further thereunder are the sheet cores 104.

Fig. 6(C): In the current detector 104 of the fourth embodiment, two kinds of the sheet cores 104, 106 are arranged irregularly (at random) in an up and down laminating direction. The order in which the sheet cores 104, 106 are laminated is totally at random, and the number of the sheet cores 104 and the number of the sheet cores 106 in the magnetic core 108 are not always equal. In an extreme case, the number of either the sheet cores 104 or the sheet cores 106 may be only one, and all the others may be the other sheet cores.

In any case, as a result of the verification conducted by the inventors of the present invention, it has been confirmed that in the second to fourth embodiments, good output linearity, hysteresis width, saturation characteristic substantially on the same level as those of the first embodiment are also obtained.

[Fifth Embodiment]

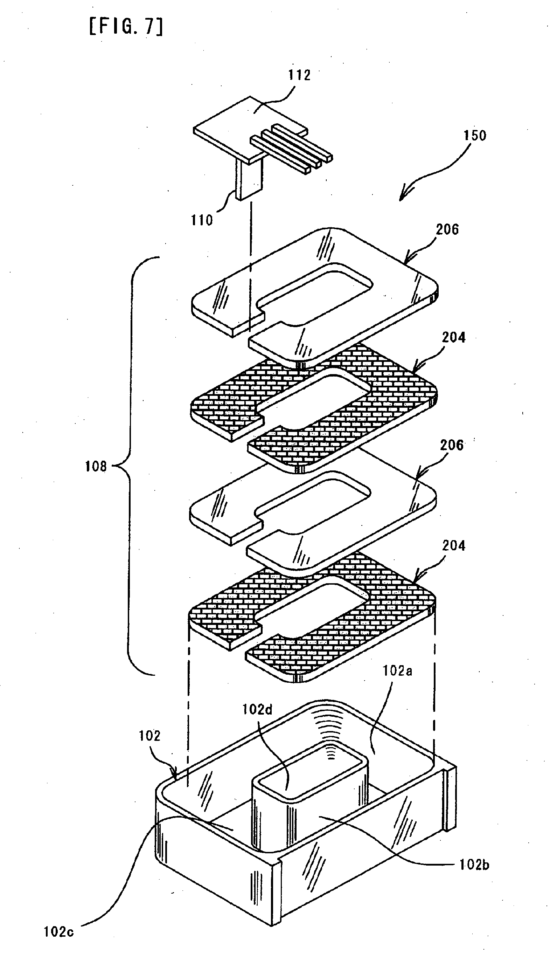

Fig. 7 is a perspective view of a current detector 150 of a fifth embodiment disassembled into constituent elements. The current detector 150 of the fifth embodiment also has a magnetic core 108 having a structure in which a plurality of kinds of sheet cores 204, 206 are laminated, but magnetic materials of the sheet cores 204, 206 are different from those of the first to fourth embodiments. Specifically, the materials of both the sheet cores 104, 106 shown in the first to fourth embodiments are the directional silicon steel plates. In the fifth embodiment, the sheet cores 204 uses an iron-nickel alloy (for example, PB = 45% permalloy, PC = 78% permalloy) as the material, and the other sheet cores 206 uses nondirectional silicon steel plates as the material.

In this case, the sheet cores 206 are the nondirectional silicon steel plates and are inferior in some of the magnetic characteristics as the core for current detection (hysteresis width in particular), but the other sheet cores 204 are made of the permalloy and have excellent magnetic characteristics as the core for current detection (output linearity, hysteresis width, saturation characteristic). By laminating these sheet cores 204, 206 made of the different magnetic materials to form the magnetic core 108, it is possible to compensate for the drawback unique to the sheet cores 206 by the other sheet cores 204. As a result, the whole magnetic core 108 can exhibit good magnetic characteristics, and can exhibit sufficient characteristics as a product.

Further, in the fifth embodiment, since the nondirectional silicon steel plate which is a relatively low-cost magnetic material and the permalloy which is a relatively expensive magnetic material are combined for use, a ratio of an amount used of the permalloy in the whole magnetic core 108 can be reduced, which accordingly can contribute to the saving of the material cost.

Incidentally, the current detector 150 of the fifth embodiment can also be expanded to the following variations.

(1) A layer of two kinds of the sheet cores 204, 206 may be divided into an upper portion and a lower portion in the up and down laminating direction. For example, an upper half thereof may be a layer composed only of the sheet cores 204 and a lower half may be a layer composed only of the other sheet cores 206.

(2) Layers composed of two kinds of the sheet cores 104, 106 respectively may be alternately laminated, each layer having a predetermined number (two or more) of the sheet cores 104 or 106. For example, the pattern may be such that two sheets in the uppermost layer are the sheet cores 204, two sheets in a layer thereunder are the other sheet cores 206, and two sheets in a layer further thereunder are the sheet cores 204.

(3) Two kinds of the sheet cores 204, 206 may be arranged irregularly (at random) in the up and down laminating direction. The order in which the sheet cores 204, 206 are laminated is totally at random and the number of the sheet cores 204 and the number of the sheet cores 206 in the magnetic core 108 need not be equal to each other. In an extreme case, the number of the sheet cores 204 may be one and all the others may be the sheet cores 206. In this case, it is possible to reduce an amount used of the expensive permalloy to minimum to reduce the material cost to minimum.

Further, the present invention is not limited to the embodiments described above, and may be embodied by being variously modified. For example, concrete specifications such as the shape, size, and thickness of the sheet cores can be changed appropriately according to the characteristics of a current to be actually detected.

Besides, the structures described in the embodiments with reference to the drawings are only preferable examples, and it goes without saying that, even when various kinds of elements are added to the basic structure or part thereof is replaced, the present invention can be suitably carried out.

## Claims

1. A current detector (100) comprising:

a current conduction part (102d) through which a current to be detected is conducted;

a magnetic core (108) disposed around said current conduction part (102d); and

a Hall element (110) disposed in a gap formed in said magnetic core (108) and converting a magnetic field generated through said magnetic core (108) when the current to be detected is conducted, into a voltage signal,

the current detector (100) **characterized in that** said magnetic core (108) has a structure in which two kinds of directional silicon steel plates (104, 106) whose easy magnetization directions are orthogonal to each other are plurally laminated in a conduction direction of a current to be detected.

2. A current detector (100) according to claims 1, wherein
said magnetic core (108) forms a rectangular magnetic circuit in a periphery of a current to be detected when seen in a laminating direction of the two kinds of directional silicon steel plates (104, 106).

3. The current detector (100) according to claim 1 or 2, wherein
said magnetic core (108) has a pair of long side portions (104c, 106c) facing each other across said current conduction part and a pair of short side portions (104d, 106d) facing each other across said current conduction part (102d), and the easy magnetization directions of the directional silicon steel plates are defined along lengths directions of the long side portions (104c, 106c) and the short side portions (104d, 106d) respectively.

4. The current detector according to any one of claims 1 to 3, wherein
said magnetic core (108) has a structure in which two kinds of the directional silicon steel plates (104, 106) whose easy magnetization directions are orthogonal to each other are alternately laminated.

## Patentansprüche

1. Stromdetektor (100), der Folgendes umfasst:

- einen Stromleitungsteil (102d), durch den ein zu detektierender Strom geleitet wird;
- einen Magnetkern (108), der um den Stromleitungsteil (102d) herum angeordnet ist; und
- ein Hall-Element (110), das in einem Spalt angeordnet ist, der in dem Magnetkern (108) ausgebildet ist, und ein durch den Magnetkern (108) erzeugtes Magnetfeld in ein Spannungssignal umwandelt, wenn der zu detektierende Strom geleitet wird,

wobei der Stromdetektor (100) **dadurch gekenn-**

**zeichnet ist, dass** der Magnetkern (108) eine Struktur hat, bei der zwei Arten direktionaler Siliziumstahlplatten (104, 106), deren leichte Magnetisierungsrichtungen orthogonal zueinander verlaufen, mehrfach in einer Leitungsrichtung eines zu detektierenden Stroms laminiert sind.

2. Stromdetektor (100) nach Anspruch 1, wobei der Magnetkern (108), in einer Laminierungsrichtung der beiden Arten direktionaler Siliziumstahlplatten (104, 106) betrachtet, einen rechteckigen Magnetkreis in einer Peripherie eines zu detektierenden Stroms bildet.

3. Stromdetektor (100) nach Anspruch 1 oder 2, wobei der Magnetkern (108) ein Paar langer Seitenabschnitte (104c, 106c) aufweist, die einander über den Stromleitungsteil hinweg zugewandt sind, sowie ein Paar kurzer Seitenabschnitte (104d, 106d) hat, die einander über den Stromleitungsteil (102d) hinweg zugewandt sind, und die leichten Magnetisierungsrichtungen der direktionaler Siliziumstahlplatten entlang von Längsrichtungen der langen Seitenabschnitte (104c, 106c) bzw. der kurzen Seitenabschnitte (104d, 106d) definiert sind.

4. Stromdetektor nach einem der Ansprüche 1 bis 3, wobei der Magnetkern (108) eine Struktur aufweist, bei der zwei Arten direktionaler Siliziumstahlplatten (104, 106), deren leichte Magnetisierungsrichtungen orthogonal zueinander verlaufen, abwechselnd laminiert sind.

## Revendications

1. Détecteur de courant (100) comprenant :

- une partie de conduction de courant (102d) à travers laquelle un courant à détecter est conduit ;
- un noyau magnétique (108) disposé autour de ladite partie de conduction de courant (102d) ; et
- un élément à effet Hall (110) disposé dans un entrefer formé dans ledit noyau magnétique (108) et convertissant un champ magnétique généré par l'intermédiaire dudit noyau magnétique (108) lorsque le courant à détecter est conduit, en un signal de tension,

le détecteur de courant (100) étant **caractérisé en ce que** ledit noyau magnétique (108) dispose d'une structure dans laquelle deux types de plaques de direction d'acier en silicium (104, 106) dont les directions d'aimantation facile sont orthogonales entre elles sont laminées dans une direction de conduction d'un courant à détecter.

2. Détecteur de courant (100) selon la revendication 1, dans lequel ledit noyau magnétique (108) forme un circuit magnétique rectangulaire dans une périphérie d'un courant à détecter lorsque observé dans une direction de stratification des deux types de plaques d'acier directionnel en silicium (104, 106).

3. Détecteur de courant (100) selon la revendication 1 ou 2, dans lequel ledit noyau magnétique (108) dispose d'une paire de parties latérales longues (104c, 106c) se faisant mutuellement face à travers ladite partie de conduction de courant et une paire de parties latérales courtes (104d, 106d) se faisant mutuellement faces à travers ladite partie de conduction de courant (102d), et les directions d'aimantation facile des plaques d'acier directionnel en silicium sont définies le long de directions de longueurs des parties latérales longues (104c, 106c) et des parties latérales courtes (104d, 106d) respectivement.

4. Détecteur de courant selon l'une quelconque des revendications 1 à 3, dans lequel ledit noyau magnétique (108) dispose d'une structure dans laquelle deux types des plaques d'acier directionnel en silicium (104, 106) dont les directions d'aimantation facile sont orthogonales entre elles sont laminées alternativement.

[FIG. 1]

[FIG. 2]

[FIG.3]

OUTPUT LINEARITY

LAMINATE TYPE 1
LAMINATE TYPE 2
LAMINATE TYPE 3
TOROIDAL

INPUT CURRENT (A)

OUTPUT VOLTAGE (V)

[FIG.4]

EP 2 124 067 B1

| CURRENT TO BE DETECTED If (A) | LINEARITY ERROR RATIO (%) | | | | |
|---|---|---|---|---|---|
| | LAMINATE TYPE 1 | LAMINATE TYPE 2 | LAMINATE TYPE 3 | | TOROIDAL |
| 50 | −1.196 | −3.651 | 0.472 | | −0.220 |
| 100 | −0.490 | −0.903 | −0.081 | | 0.046 |
| 150 | 0.285 | 1.146 | −0.199 | | 0.021 |
| 200 | 0.921 | 2.497 | −0.151 | | 0.113 |
| 250 | 1.401 | 3.408 | −0.192 | | 0.153 |

[FIG.5]

| | LAMINATE TYPE 1 | LAMINATE TYPE 2 | LAMINATE TYPE 3 | | TOROIDAL |
|---|---|---|---|---|---|
| +If(A)→O(A) | 2.5080 | 2.5110 | 2.5000 | | 2.5000 |
| −If(A)→O(A) | 2.4900 | 2.4850 | 2.4960 | | 2.4970 |
| HYSTERESIS WIDTH | 0.0090 | 0.0130 | 0.0020 | | 0.0015 |

[FIG. 6]

[FIG. 7]

112

150

110

206

204

206

108

204

102a

102d

102

102b

102c

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003017347 A
- JP HEI9281152 B
- FR 2764707
- JP H09162050 B
- JP 2003031421 A
- JP 2001050987 A